# EUROPEAN PATENT APPLICATION

(11) **EP 2 477 337 A1**
(43) Date of publication of application: **18.07.2012**
(21) Application number: 10815278.6
(22) Date of filing: 27.08.2010
(51) Int. Cl.: H04B 1/16, H03G 3/20, H03H 7/25

(54) **ATTENUATION CONTROL DEVICE, SIGNAL ATTENUATION DEVICE, AUTOMATIC GAIN CONTROL DEVICE, ATTENUATION CONTROL METHOD, AND AUTOMATIC GAIN CONTROL METHOD**

(30) Priority: 11.09.2009 JP 2009210209
(71) Applicant: Mitsumi Electric Co., Ltd., Tama-shi Tokyo 206-8567 (JP)
(72) Inventor: YASHIMA, Kiminori, Tama-Shi Tokyo 206-8567 (JP)
(74) Representative: Collin, Jérôme
(86) International application number: PCT/JP2010/064626
(87) International publication number: WO 2011/030681

(57) **Abstract**

An attenuation control device is provided in a receiver of a high-frequency signal and attenuates the high-frequency signal. The attenuation control device includes a computing unit to output digital data for controlling an amount of attenuation of the high-frequency signal, and a DA converter to perform DA conversion of the digital data into a control current which controls a current which is passed through a PIN diode for attenuating the high-frequency signal, wherein the DA converter outputs an analog current as the control current, which is corrected so that a logarithmic value of the amount of attenuation of the high-frequency signal is allowed to change substantially linearly to the digital data.

## Description

### TECHNICAL FIELD

The present disclosure relates to an attenuation control device, a signal attenuation device, an automatic gain control device, an attenuation control method, and an automatic gain control method which are used in a receiver that receives a high frequency signal.

### BACKGROUND ART

If a large amplitude signal is input to a receiver, intermodulation (IM) distortion is present in a circuit having a nonlinear component, such as a low noise amplifier (LNA), of the receiver. If so, the characteristic of the receiver, such as a signal-to-noise ratio (SNR), is reduced. To avoid such a problem, there exists a method of suppressing the presence of intermodulation distortion. In this method, a signal attenuation circuit is connected to the preceding stage circuit of the circuit having the nonlinear component in the receiver, so that the signal input to the circuit having the nonlinear component is attenuated.

If the input signal is attenuated by the signal attenuation circuit, the intermodulation distortion may be suppressed. However, there may be a case in which the amplitude of an undesired signal is large, the amplitude of a desired signal (reception signal) is small (weak input), and the two signals are simultaneously input to the receiver. In this case, even if the input signal is attenuated by the signal attenuation circuit, another problem will occur. Namely, a desired signal having a very small amplitude would also be attenuated, so that the reception sensitivity would decrease.

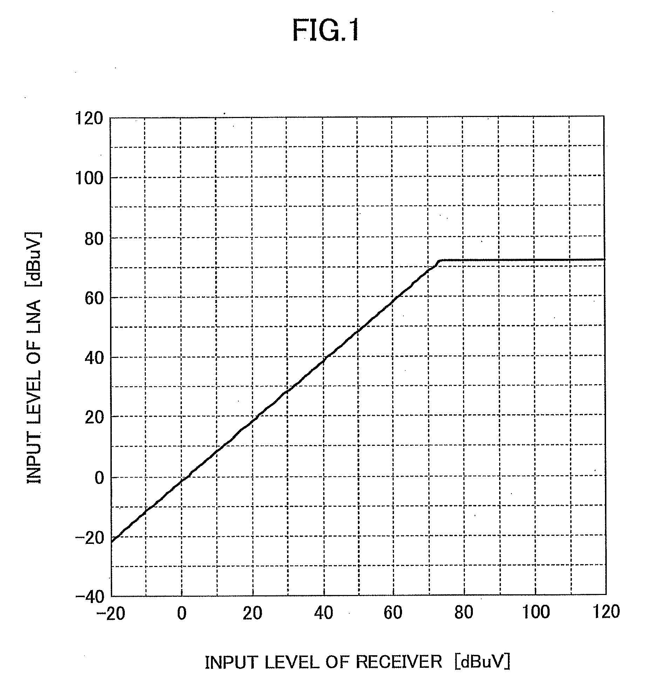

In order to suppress the influence of such a problem, for example, the use of an automatic gain control (AGC) circuit is effective. In this circuit, the amplitude of a signal input to the circuit having the nonlinear component is limited to a maximum level that causes only a permissible intermodulation distortion, as shown in FIG. 1. In such a case, if a signal having a very large amplitude exceeding the maximum level is input to the receiver, the amplitude of the input signal is attenuated to the maximum level, thereby avoiding the problem. Accordingly, the use of an automatic gain control (AGC) circuit which controls the gain to keep constant the amplitude of the signal input to the circuit having the nonlinear component is effective.

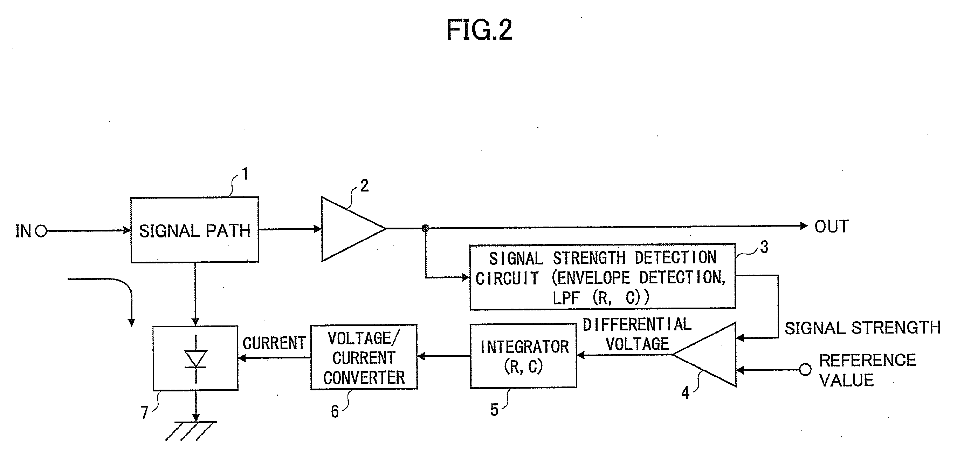

FIG. 2 shows an example of the AGC circuit according to the related art for realizing the gain characteristic shown in FIG. 1.

An input signal IN is input to a circuit 2 having a nonlinear component, such as LNA, via a signal path 1. A differential amplifier 4 amplifies the difference between a predetermined reference value and the level of an output signal OUT of the circuit 2 having the nonlinear component, which level is detected by a signal strength detection circuit 3. An integrator 5 outputs a signal indicating the integration of a difference voltage obtained from the difference amplified by the differential amplifier 4. A voltage/current converter 6 outputs a current signal equivalent to the output voltage of the integrator 5. The current signal from the voltage/current converter 6 is passed through a PIN (p-type, intrinsic, n-type) diode of an attenuation circuit 7, so that the input signal IN is attenuated.

For example, Patent Document 1 listed below discloses a variable attenuator in the type of changing the current passed through the PIN diode to change the amount of attenuation.

### DISCLOSURE OF THE INVENTION

### PROBLEM TO BE SOLVED BY THE INVENTION

However, the analog signal strength detection circuit 3 shown in FIG. 2 is provided to detect the amplitude component of the input signal by envelope detection, and the signal strength detection circuit 3 requires an LPF (low pass filter), such as an RC circuit. In order to produce the analog signal strength detection circuit on an IC chip, it is necessary to secure a large area for arranging a capacitor of the RC circuit within the IC chip or to attach the capacitor of the RC circuit to the IC chip externally.

Moreover, the integrator 5 shown in FIG. 2 requires an RC circuit similarly, and it is necessary to secure a large area for arranging a capacitor of the RC circuit within the IC chip or to attach the capacitor of the RC circuit to the IC chip externally. The arrangement of such capacitors contradicts the objective of an SoC (system-on-chip), which is making the chip size smaller and reducing the number of external parts as much as possible to attain reduced manufacture cost.

On the other hand, in a case of a receiver for a mobile device, the input level of a high frequency signal may change with movement of the receiver. If the increase/decrease width (resolution) of the attenuation of the high frequency signal by the attenuation circuit is not fixed, the characteristic of the receiver, such as SNR, changes considerably with only a slight change of the input level of the high frequency signal.

Accordingly, in one aspect, the present disclosure provides an attenuation control device, a signal attenuation device, an automatic gain control device, an attenuation control method, and an automatic gain control method which are capable of minimizing fluctuations of the amount of attenuation of the high frequency signal by the attenuation circuit, and attaining the device miniaturization.

### MEANS TO SOLVE THE PROBLEM

In an embodiment which solves or reduces one or more of the above-mentioned problems, the present disclosure provides an attenuation control device which is provided in a receiver of a high frequency signal and attenuates the high frequency signal, the attenuation control device including: a data output part to output digital data for controlling an amount of attenuation of the high frequency signal; and a DA converter to perform DA conversion of the digital data into a control current for controlling a current which is passed through a PIN diode for attenuating the high frequency signal, wherein the DA converter is arranged to output an analog current as the control current, the analog current being corrected to allow a logarithmic value of the amount of attenuation of the high frequency signal to change linearly to the digital data.

In an embodiment which solves or reduces one or more of the above-mentioned problems, the present disclosure provides an attenuation control method which is performed by an attenuation control device provided in a receiver of a high frequency signal to attenuate the high frequency signal, the method including: a data output step of outputting by a data output part digital data for controlling an amount of attenuation of the high frequency signal; a DA conversion step of performing by a DA converter DA conversion of the digital data into a control current for controlling a current which is passed through a PIN diode for attenuating the high frequency signal; and a current output step of outputting by the DA converter a corrected analog current as the control current so that a logarithmic value of the amount of attenuation of the high frequency signal is allowed to change linearly to the digital data.

In an embodiment which solves or reduces one or more of the above-mentioned problems, the present disclosure provides an automatic gain control method which is performed by an automatic gain control device provided in a receiver of a high frequency signal to control a gain of the high frequency signal, the method including: an amplification step of amplifying, by an amplifier, the high frequency signal attenuated by a PIN diode for attenuating the high frequency signal; a strength detection step of detecting, by a signal strength detection circuit, a strength of the high frequency signal amplified in the amplification step; a data output step of outputting, by a data output part, digital data for controlling an amount of attenuation of the high frequency signal by the PIN diode, in response to a difference between the strength detected in the strength detection step and a predetermined reference value; a DA conversion step of performing, by a DA converter, DA conversion of the digital data into a control current for controlling a current which is passed through the PIN diode; and a current output step of outputting, by the DA converter, a corrected analog current as the control current so that a logarithmic value of the amount of attenuation of the high frequency signal by the PIN diode is allowed to change linearly to the digital data.

### EFFECT OF THE INVENTION

According to the present disclosure, the DC offset and frequency offset can be compensated with good accuracy and high speed, without increasing the circuit size.

### BRIEF DESCRIPTION OF THE DRAWINGS

FIG. 1 is a diagram showing the gain characteristic of an AGC circuit which keeps the input level of an LNA constant in a signal attenuation circuit.
FIG. 2 is a diagram showing the composition of an AGC circuit according to the related art for realizing the gain characteristic shown in FIG. 1.
FIG. 3 is a diagram showing the composition of an AGC circuit which is an embodiment of the automatic gain control device of the present disclosure.
FIG. 4 is a diagram showing the composition of a signal path connected to an attenuation circuit.
FIG. 5 is a circuit diagram showing an example of the signal path shown in FIG. 4.
FIG. 6 is a block diagram showing the composition of a comparator and a computing unit.
FIG. 7 is a diagram showing the relationship between the forward current and the resistance of a PIN diode.
FIG. 8 is a diagram showing the relationship between the resistance of a damping resistor and the attenuation of the input/output signals of a signal path of a high impedance in the case of dumping the signal path by the damping resistor.
FIG. 9 is a diagram showing the forward current for obtaining the attenuation of 0-60 dB by using two PIN diodes.
FIG. 10 is a diagram showing the input/output characteristics of a DA converter which outputs an analog current of 0-16mA which is linear to K-bit input data (K=8, input data = 0-255).
FIG. 11 is a diagram showing the relationship between the input value of the DA converter and the signal attenuation when the linear output current of the DA converter having the characteristics of FIG. 10 is supplied to the PIN diode.
FIG. 12 is a diagram showing the relationship between the input value and the resolution of the signal attenuation of the DA converter having the characteristics of FIG. 10.
FIG. 13 is a diagram showing the composition of the DA converter 11 including 16 current output blocks (N = 4) .
FIG. 14 is a diagram showing the composition of one current output block including five current output blocks.
FIG. 15 is a diagram showing a total of 16 plotting points on the graph portion of a range where the required attenuation G shown in FIG. 9 is obtained corresponding to the control current I for the division points obtained by approximating the graph portion with four straight lines with different gradients and by dividing each straight line into the division points at four logarithmically equal intervals.
FIG. 16 is a diagram showing the relationship between the current value I and the amount of step changes Is of the current value I at each division point.
FIG. 17 is a diagram showing the relationship between the input digital data D of the DA converter of the present disclosure and the signal attenuation G obtained when the control current I is supplied to the PIN diode.
FIG. 18 is a diagram showing the relationship between the input digital data D and the resolution of the signal attenuation of the DA converter of the present disclosure.
FIG. 19 is a diagram showing a linear attenuation characteristic (ideal curve).
FIG. 20 is a diagram showing a non-linear attenuation characteristic.
FIG. 21 is a diagram showing the relationship between the interfering signal input and the AGC output in the case of the linear attenuation characteristic.
FIG. 22 is a diagram showing the relationship between the interfering signal input and the AGC output in the case of the non-linear attenuation characteristic.
FIG. 23 is a diagram showing the relationship between the interfering signal input and the demodulation SNR of the desired signal in the case of the linear attenuation characteristic.
FIG. 24 is a diagram showing the relationship between the interfering signal input and the demodulation SNR of the desired signal in the case of the non-linear attenuation characteristic.
FIG. 25 is a flowchart for explaining an attenuation control method and an automatic gain control method which are performed by the AGC circuit of the present embodiment.

### BEST MODE FOR CARRYING OUT THE INVENTION

A description will be given of embodiments of the present disclosure with reference to the accompanying drawings.

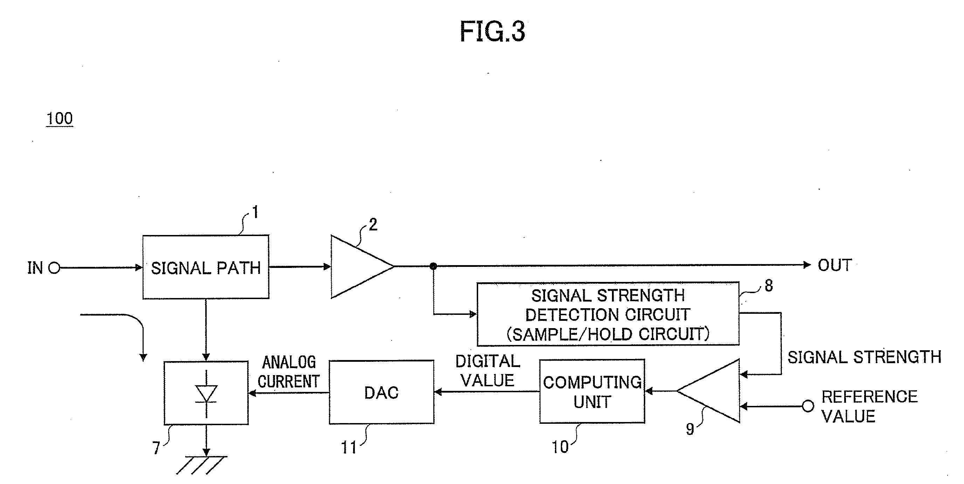

FIG. 3 is a diagram showing the composition of an AGC circuit 100 which is an embodiment of the automatic gain control device of the present disclosure.

The AGC circuit 100 includes a DA converter (DAC) 11 which outputs an analog current signal in response to a digital data input. This DA converter functions as a current supply unit to supply current to a PIN (p-type, intrinsic, n-type) diode contained in an attenuation circuit 7 connected to a signal path 1 of a high frequency signal. The AGC circuit 100 includes a signal strength detection circuit (sample/hold circuit) 8 which detects the strength of an output signal of a circuit 2 having a nonlinear component, such as LNA (low noise amplifier), and a comparator 9 which compares the level of the strength detected by the sample/hold circuit 8 with a predetermined reference value. The AGC circuit 100 further includes a computing unit 10 which is operated according to the comparison result from the comparator 9 and outputs the digital data input to the DA converter 11.

In the AGC circuit 100, the DA converter 11 is constructed and the portion of the analog circuit according to the related art can be replaced by digital circuit elements, such as logic circuits, (for example, the sample/hold circuit 8, the comparator 9 and the computing unit 10). Hence, the AGC circuit 100 does not require the LPF and the integrator which include the capacitors with a large electrostatic capacity, so that it is possible to reduce the size of the AGC circuit 100.

The AGC circuit 100 includes an attenuation control circuit including the computing unit 10 and the DA converter 11, which is an embodiment of the attenuation control device of the present disclosure. The AGC circuit 100 includes a signal attenuation circuit mainly including the computing unit 10, the DA converter 11 and the attenuation circuit 7 connected to the signal path 1, which is an embodiment of the signal attenuation device of the present disclosure. These circuits of the embodiments of the present disclosure are built in a receiver of a high frequency signal, such as FM broadcast band radio signal.

The computing unit 10 is a data output part which outputs digital data for controlling the amount of attenuation of the high frequency signal by the attenuation circuit 7. The DA converter 11 performs DA conversion of the digital data output from the computing unit 10 to output a corrected control current signal so that the attenuation characteristic of the corrected control signal is substantially linear to the digital data of the attenuation circuit 7. The attenuation circuit 7 includes a PIN diode for attenuating the high frequency signal received via the antenna.

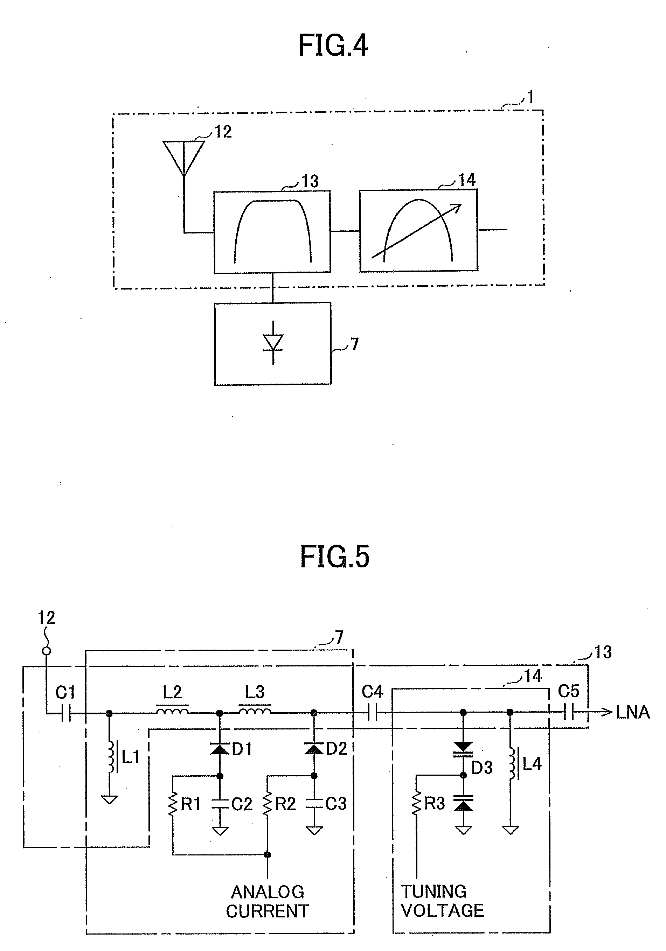

FIG. 4 is a block diagram showing the composition of the signal path 1 connected to the attenuation circuit 7. The signal path 1 is constructed to include an antenna terminal 12 which is electrically connected to an antenna for receiving an electric wave, a band pass filter 13 to which a high frequency signal is input via the antenna terminal 12, and a tuning circuit 14 to which an output signal of the band pass filter 13 is input. The attenuation circuit 7 is connected to the band pass filter 13 so that the high frequency signal passed through the band pass filter 13 attenuated by the attenuation circuit 7 and the attenuated signal is output.

FIG. 5 is a circuit diagram showing an example of the signal path shown in FIG. 4.

The band pass filter 13 includes a series circuit in which a capacitor C1, an inductor L2, an inductor L3, a capacitor C4 and a capacitor C5 are connected in series, in this sequence, and an inductor L1 disposed between the junction point of the capacitor C1 and the inductor L2 and the ground. One end of the capacitor C1 is connected to the antenna terminal 12, and one end of the capacitor C5 is connected to the circuit 2 having a nonlinear component, such as LNA.

The tuning circuit 14 includes a parallel circuit of a diode D3 and an inductor L4, and a resistor R3 which supplies a tuning voltage to an intermediate terminal of the diode D3. The parallel circuit of the tuning circuit 14 is connected to the path between the capacitors C4 and C5. The diode D3 is an element which is provided with the intermediate terminal which is the junction point where the cathodes of two variable capacitance diodes are connected together.

The tuning circuit 14 performs synchronizing operation to take out a high frequency signal of a desired frequency band to be demodulated (for example, FM-broadcast band) from the high frequency signal produced by receiving the electric wave at the antenna.

The tuning circuit 14 can change a frequency band of a signal component which is taken out from the high frequency signal produced by receiving the electric wave at the antenna, in response to a externally supplied tuning voltage. Hence, the tuning circuit 14 can take out the signal component of the frequency band according to the tuning voltage, from the high frequency signal produced by receiving the electric wave at the antenna.

The attenuation circuit 7 is provided with the following elements. The attenuation circuit 7 includes an inductor L1, an inductor L2, an inductor L3, a PIN diode D1 in which the cathode thereof is connected to the junction point of the inductors L2 and L3, a capacitor C2 disposed between the anode of the PIN diode D1 and the ground, a resistor R1 which is connected to the junction point of the PIN diode D1 and the capacitor C2 and disposed in a feed path of an analog current output from the DA converter 11, a PIN diode D2 in which the cathode thereof is connected to the junction point of the inductor L3 and the capacitor C4, a capacitor C3 disposed between the anode of the PIN diode D2 and the ground, and a resistor R2 which is connected to the junction point of the PIN diode D2 and the capacitor C3 and disposed in the feed path of the analog current output from the DA converter 11.

In the attenuation circuit 7, if the analog current flows in the path of R1, D1, L2, L1 and in the path of R2, D2, L3, L2, L1, the PIN diodes D1 and D2 become an element equivalent to a resistor element. Hence, the high frequency signal input from the antenna terminal 12 is attenuated by falling to the ground in the path of D1 and C2 and in the path of D2 and C3.

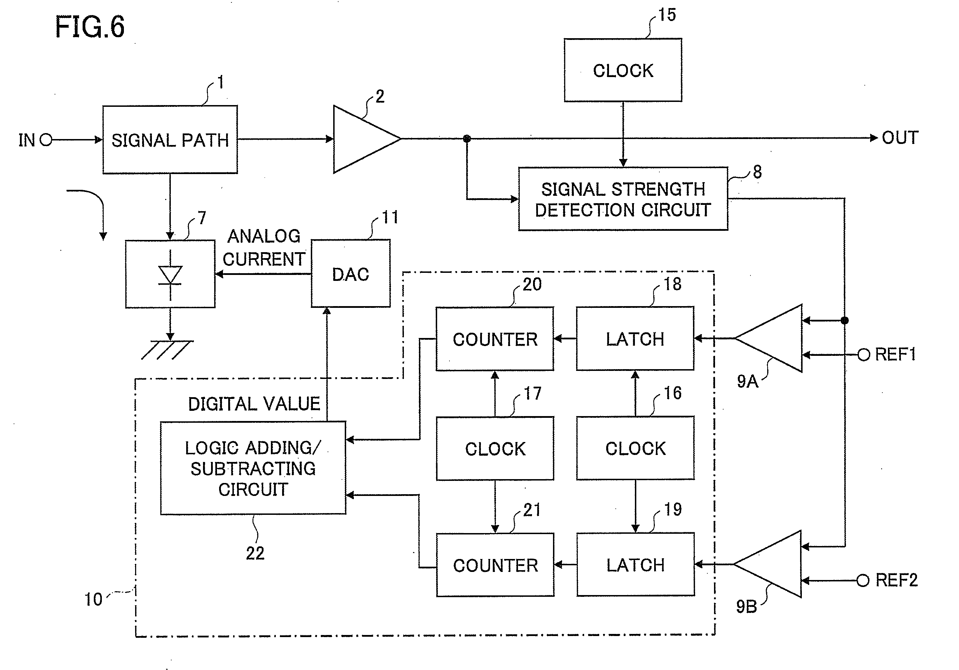

FIG. 6 is a block diagram showing the composition of the comparator 9 and the computing unit 10.

The sample/hold circuit 8 performs, at a sample/hold cycle according to the clock period of a clock 15, sampling and holding of the high frequency signal output from the circuit 2 having the nonlinear component. The frequency of the clock 15 is on the order of 10 MHz, for example, 12 MHz. With such a frequency, the value of the capacitance used for the sample/hold circuit 8 is in a range of 0.1-0.2 pF, and the circuit can be mounted on a small area on the chip.

The output signal obtained by the sampling and holding is input to the comparator 9. The comparator 9 includes a first comparator 9A and a second comparator 9B. The comparator 9A compares the output signal obtained by the sampling and holding, with a predetermined reference value REF1. The comparator 9B compares the output signal obtained by the sampling and holding, with a predetermined reference value REF2. The reference value REF2 is smaller than the reference value REF1 (for example, by 3 dB) .

The latch circuit 18 (19) latches the output signal of the comparator 9A (9B) while being reset according to the clock 16. The frequency of the clock 16 is 10kHz, for example. The output signal of the latch circuit 18 (19) is input to the counter 20 (21). The input of "1" is counted by the counter 20 and the input of "0" is counted by the counter 21. That is, in the counter 20, the state where the signal level is larger than the reference value REF1 is counted, and the state where the signal level is smaller than the reference value REF2 is counted by the counter 21.

The counter 20 is reset according to the clock 17, and outputs "1", for example, if "1" is counted 4 times within a period which is predetermined with the clock 17. The counter 21 is reset according to the clock 17, and outputs "1", for example, if "0" is counted once within the period which is predetermined with the clock 17. The frequency of the clock 17 is, for example, 1/5 of the frequency of the clock 16 (or the clock 17 has a period 5 times longer of the period of the clock 16).

The output signals of the counter 20 and the counter 21 are input to the logic adding/subtracting circuit 22. The logic adding/subtracting circuit 22 generates digital data to be input to the DA converter 11 in the direction which attenuates the high frequency signal input to the signal path 1 when the output value of the counter 20 is "1", and generates digital data in the direction which does not attenuate the high frequency signal input to the signal path 1 when the output value of the counter 21 is "1". The resulting digital data is output to the DA converter 11.

The DA converter 11 outputs an analog current to the attenuation circuit 7 by performing DA conversion of the input digital data. The forward current according to this analog current is passed through the PIN diode of the attenuation circuit 7.

When a signal with a level exceeding the reference value REF1 is present, automatic gain control is performed by the AGC circuit 100 using the circuit loop, so that the signal level is set to a value between the reference value REF1 and the reference value REF2.

As described above, the PIN diode has the characteristic of a resistor element, and the resistance of the PIN diode changes by the forward current passed through the PIN diode.

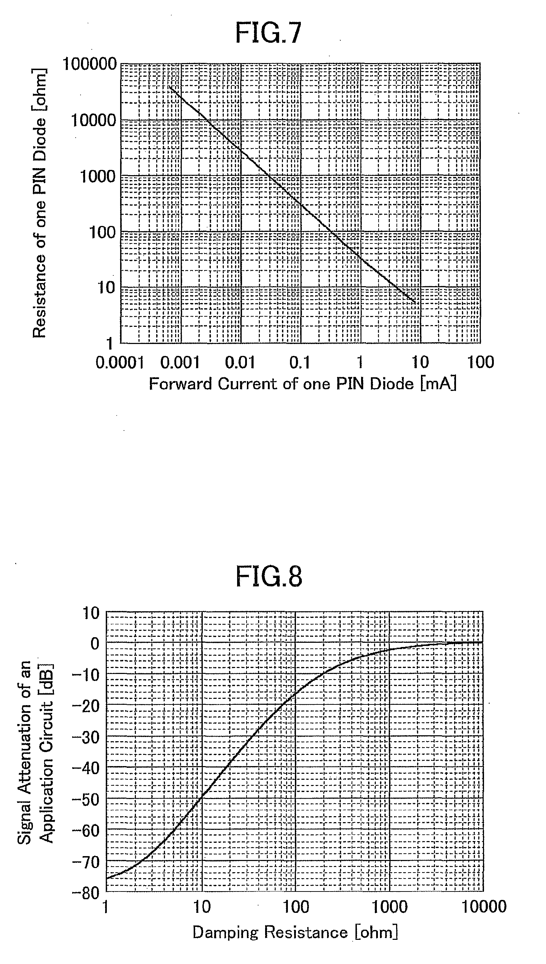

FIG. 7 is a diagram showing the relationship between the forward current and the resistance of one PIN diode. As the forward current increases, the resistance decreases. A logarithmic value of the forward current and a logarithmic value of the resistance are in inverse proportion.

Therefore, by passing the forward current through the PIN diode 7 connected between the signal path 1 and the ground (AC-GND), the signal path 1 with a high impedance will be dumped by the resistor with a small value, and the input signal IN can be attenuated.

FIG. 8 is a diagram showing the relationship between the resistance of a dumping resistor and the attenuation G of the input/output signals of a signal path 1 of a high impedance in the case of dumping the signal path 1 by the dumping resistor.

The attenuation G of the input/output signals of the signal path 1 is an amount of attenuation by which the level E2 of an output signal sent from the signal path 1 to the LNA 2 is decreased from the level E1 of an input signal to the signal path 1. The attenuation characteristic of the signal path 1 is represented by an attenuation ratio (E2/E1) in dB. The attenuation G of the input/output signals of the signal path 1 is represented by the formula: G = 20 log₁₀ (E2/E1) (in dB). As shown in FIG. 8, the attenuation increases as the resistance of the dumping resistor decreases.

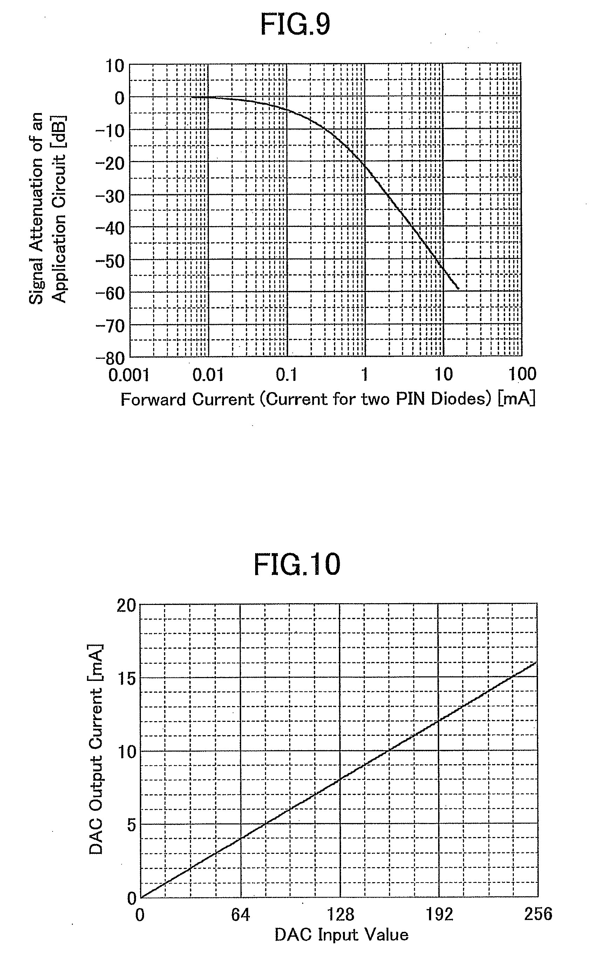

FIG. 9 is a diagram showing the forward current for obtaining the attenuation of 0-60 dB by using two PIN diodes. The data of FIG. 9 is obtained based on the data of FIGS. 7 and 8. The horizontal axis of FIG. 9 is represented by the logarithmic value of the forward current of the PIN diodes, and the vertical axis is represented by the logarithmic value of the attenuation of the high frequency signal (namely, the attenuation G). The two PIN diodes are used in order to ensure an equivalent resistance value needed for obtaining the attenuation of 60 dB. As is apparent from FIG. 9, the attenuation G of the input/output signals of the signal path 1 can be made to increase as the forward current passed through the PIN diodes 7 increases.

This forward current is supplied as the analog current (the control current) output by the DA converter 11. A common DA converter outputs an analog current (or voltage) which is linear to a digital data input to the DA converter. A DA converter having such a linear output characteristic can be easily produced. For example, in a case of the input of K-bit digital data, K current sources assigned to K bits of the input digital data respectively are arranged in a line in the DA converter. The K current sources are turned ON and OFF in accordance with the values of the K bits of the input digital data to supply current components respectively. In response to the input digital data, the DA converter outputs an analog current (control current) which is represented by the total current which is the sum of the current components output from the turned-ON current sources.

FIG. 10 is a diagram showing the input/output characteristics of a DA converter which outputs an analog current of 0-16mA which is linear to K-bit input data (K=8, input data = 0-255).

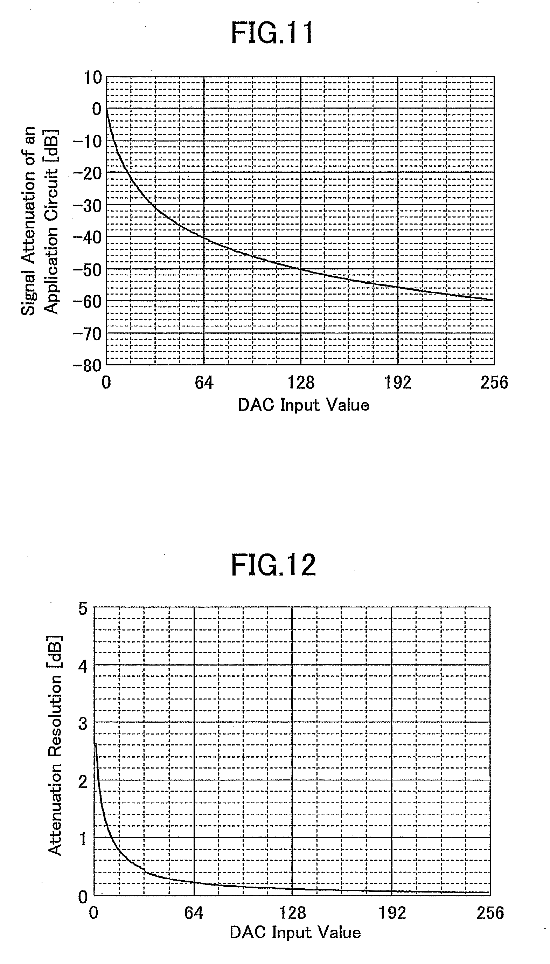

FIG. 11 shows the relationship between the input value of the DA converter and the attenuation G of the input/output signals of the signal path 1 when the linear output current of the DA converter having the linear characteristics of FIG. 10 is supplied to the PIN diode, which is obtained based on the data of FIG. 9. FIG. 12 shows changes of the attenuation G of the input/output signals of the signal path 1 to changes of the input value of the DA converter having the linear characteristic of FIG. 10 (i.e., the resolution of the attenuation G).

It is desirable for a signal attenuator that the signal attenuation changes linearly to changes of the input value of the DA converter on a logarithmic scale (dB linear), i.e., the resolution becoming a constant value. However, in the case of the DA converter having the linear flow characteristic of FIG. 10, the resolution changes from 2.6 dB to 0.05 dB as shown in FIG. 12, and the desired characteristic is not obtained (the resolution is not constant).

Accordingly, in order to make the signal attenuation change to the input value of the DA converter on a logarithmic scale (dB linear), the analog current output from the DA converter must change to the input value of the DA converter in a nonlinear manner. In order to provide such a nonlinear curve representing the change characteristics of the analog current output by the DA converter, the use of improved composition of the DA converter is conceivable. For example, the input bit number K of the DA converter is increased, and in a case of the input of K-bit digital data, 2^{K} current sources assigned to K bits of the input digital data respectively are arranged in a line in the DA converter. The 2^{K} current sources are turned ON and OFF in accordance with the values of the K bits of the input digital data to supply optimal current components respectively which are in conformity with the non-linear curve.

However, if the DA converter having such composition is adopted, for example, in the case of the input of 8-bit digital data, at least 255 current sources will be required. Moreover, variations of the current sources will affect the output characteristic of the DA converter directly.

To eliminate the problem, the DA converter 11 of the present disclosure is arranged so that the output characteristic of an optimal nonlinear current curve is obtained while the number of current sources for supplying the analog current output in response to the input digital data is minimized. Moreover, the analog current which is output by the DA converter in response to the input digital data is adjusted appropriately, so that it is possible to suppress the influence of the variations in the attenuation G of the input/output signals of the signal path 1.

Next, the composition of the DA converter 11 of the present disclosure will be described.

The digital data D of K (=N+M) bits is input to the DA converter 11 (N is an integer above 2 and M is an integer above 2).

The DA converter 11 performs DA conversion of the digital data D output from the computing unit 10 into a control current I for controlling the current which is passed through the PIN diode for attenuating the high frequency signal. The DA converter 11 outputs an analog current, as the control current I, the analog current being corrected so that the attenuation G of the high frequency signal (a logarithmic value of the attenuation of the high frequency signal) changes almost linearly to the input digital data.

In a case in which the resistance element in the circuit may be disregarded, it is assumed that a current value of the current which is actually passed through the PIN diode and a current value of the control current I are equal to each other, for the sake of simplicity of description. If the resistance element is so large that a difference between the two values may not be disregarded, the difference may be taken into consideration.

The DA converter 11 of the present disclosure includes a plurality of current output blocks, preferably, 2^{N} current output blocks (where N is an integer above 2) which are connected in parallel.

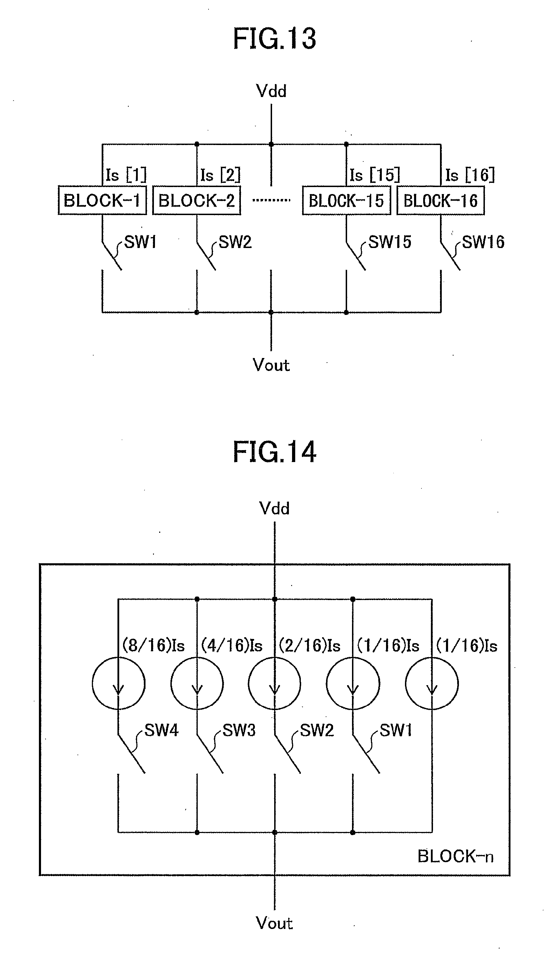

FIG. 13 is a diagram showing the composition of the DA converter 11 including 16 current output blocks (N= 4) which are connected in parallel. In FIG. 13, Vdd denotes a supply voltage to each current output block, and Vout denotes an output voltage (a terminal voltage of an output terminal of the control current I) of the DA converter 11.

The control current I is a sum of current components Is[1] - Is[N] respectively output from one or more current output blocks which are selected from among the plurality of current output blocks in accordance with N binary digits (where N is an integer above 2) of a first order bit portion of the digital data D (the higher order side). In the case of FIG. 13, the control current I is a sum of current components Is[1] - Is[16] output from one or more current output blocks which are chosen from among the 16 current output blocks.

Selection of the current output blocks to output the current is performed by N switches SW which are turned ON and OFF in accordance with the N binary digits of the first order bit portion of the digital data D. The switch SW is provided for each of the current output blocks.

In an ON/OFF state of the switch SW, the outputting of the current component from the current output block connected to the ON switch SW is turned ON, and the outputting of the current component from the current output block connected to the OFF switch SW is turned OFF. The switches SW are made of semiconductor switching elements, such as MOSFET.

Each of the plurality of current output blocks has a plurality of current sources connected in parallel, each current source provided for outputting a division current component corresponding to a current component assigned to the current source.

FIG. 14 is a diagram showing the composition of one current output block including five current sources. Each of the current components Is[1] - Is[N] output from the plurality of current output blocks is a sum of division current components respectively output from one or more current sources which are chosen from among the plurality of current sources of a corresponding one of the plurality of current output blocks in response to M binary digits (where M is an integer above 2) of a second lower-order bit portion of the digital data D which is the remainder of the first order bit portion. It is preferred that each of the plurality of current output blocks includes (M+1) current sources. In the case of FIG. 14, M= 4.

Selection of the current sources to output the current is performed by M switches SW which are turned ON and OFF in accordance with the M binary digits of the second lower-order bit portion of the digital data D. The switch SW is provided for each of the current sources.

In an ON/OFF state of the switch SW, the outputting of the division current component from the current source connected to the ON switch is turned ON, and the outputting of the division current component from the current source connected to the OFF switch SW is turned OFF. Hence, the component output Is from each current output block changes on the basis of (1/2^{M}).

The switches SW are made of semiconductor switching elements, such as MOSFET. The adoption of a current mirror type current source can suppress the variation in the current value.

Each of the current components to be assigned to the plurality of current output blocks is obtained by approximating a curve (see FIG. 9) representing the correlation data between a logarithmic value of the current which is passed through the PIN diode) and a logarithmic value of the attenuation of the high frequency signal, with a set of straight lines.

As shown in FIG. 9, in the curve representing the correlation data the logarithmic value of the forward current of the PIN diode and the logarithmic value of the signal attenuation (dB), a linear portion exists in some region and a non-linear portion exists in another region. Therefore, the curve representing the correlation data between the logarithmic values of the forward current of the PIN diode and the signal attenuation (dB) is approximated with a set of straight lines.

When the curve representing the correlation data of the logarithmic value of the control current I passed through the PIN diode and the attenuation G (dB) is approximated with the set of straight lines, a portion of the curve in a range where the attenuation G required according to the specifications is obtained may be approximated using the set of straight lines.

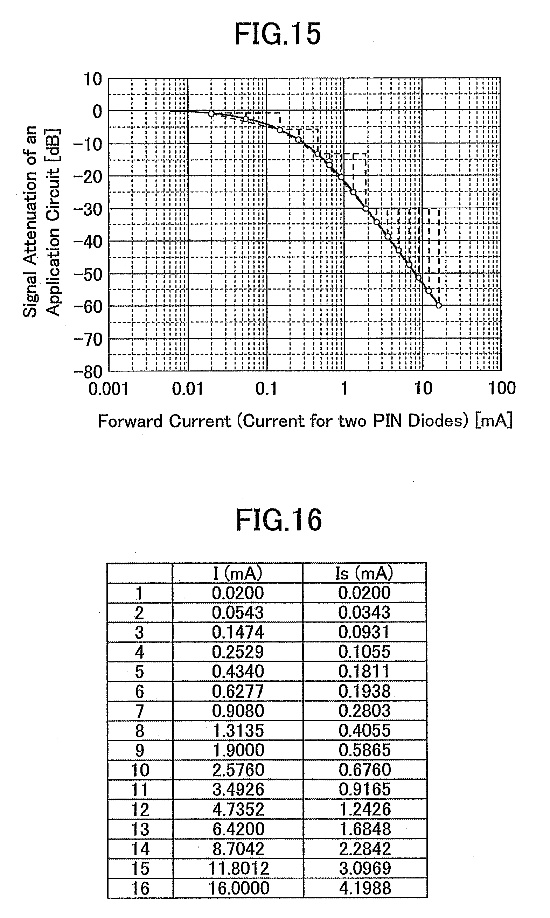

FIG. 15 is a diagram showing a total of 16 plotting points on the graph portion of a range where the required attenuation G shown in FIG. 9 is obtained corresponding to the control current I for the division points obtained by approximating the graph portion with four straight lines with different gradients and by dividing each straight line into the division points at four logarithmically equal intervals.

When the graph portion of the range where required attenuation G is obtained by using the straight lines, the intersections where the straight lines and the corresponding graph portion cross are determined. For each straight line, the range of change of the control current I between the two intersections on the corresponding graph portion is divided at equal intervals in a logarithmic scale. The number of the division portions in which the corresponding graph portion is divided at equal intervals is in agreement with the total number of the 2^{N} current output blocks of the DA converter 11. In the case of FIG. 15, the 16 division portions (N= 4) exist.

FIG. 16 is a diagram showing the relationship between the current value I and the amount of step changes Is of the current value I at each division point. The amount of step changes Is equivalent to the current component assigned to each of the plurality of current output blocks is in agreement with a range of change of the current which changes in each division portion.

For example, in a case of a DA converter 11 to which 8-bit digital data D wherein N = 4 and M = 4 (K = 8) are set up is input, as shown in FIG. 13, 16 current output blocks which output the current components Is are arranged. As shown in FIG. 14, each current output block is constructed to include a total of five circuits: a circuit to output a division current value of Is/16, a circuit to output the same division current value of Is/16, a circuit to output a division current value of Is/8, a circuit to output a division current value of Is/4, and a circuit to output a division current value of Is/2, which circuits are connected in parallel. According to the input value of the lower-order 4 bits (M= 4) of the digital data, the respective circuits are turned on or off by the switches SW1-SW4, the linear current which varies in a range of 1/16 - 16/16 of the total current component Is is output.

As shown in FIG. 13, the current output blocks with the smaller current values among the 16 current output blocks are sequentially turned ON in response to the input value of the upper-order 4 bits (N= 4) of the 8-bit digital data D. Further, the current output of the current sources within the current output block with the largest current value among the current output blocks in the ON state (FIG. 14) is controlled in response to the input value of the lower-order 4 bits (M= 4) of the digital data D.

The current sources in the current output block shown in FIG. 14 respectively have a resistance equal to that of a unit resistor, a resistance twice that of the unit resistor, a resistance 4 times that of the unit resistor, and a resistance 8 times that of the unit resistor. Resistance R of the unit resistor is determined by the following formula. $R = 16 ⁢ \left(Vdd-Vout\right) / Is$

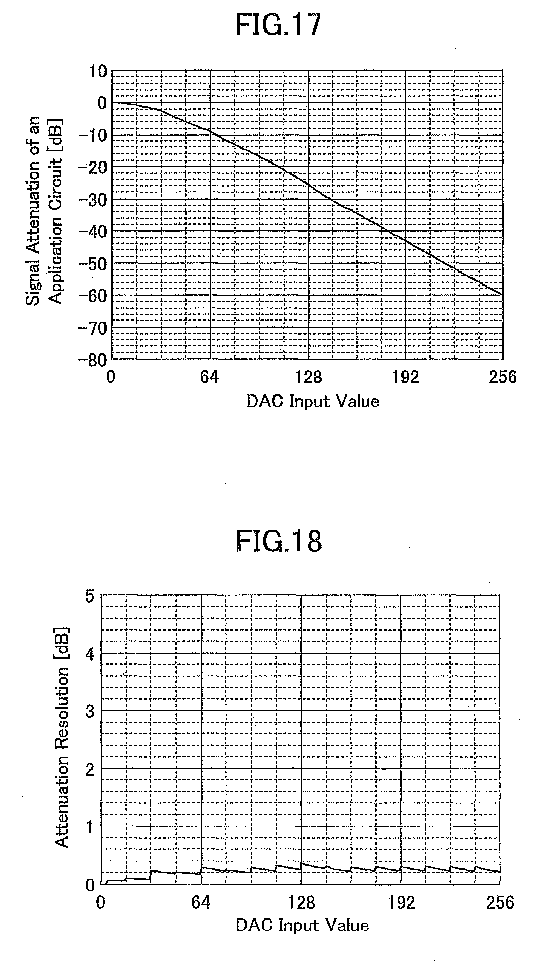

FIG. 17 shows the relationship between the input digital data D and the signal attenuation G of the DA converter of the present disclosure obtained when the control current I is supplied to the PIN diode. FIG. 18 shows the relationship between the input digital data D and the resolution of the signal attenuation G of the DA converter of the present disclosure.

As shown in FIG. 17, the amount of signal attenuation G (dB) changes linearly to changes of the input digital data D of the DA converter. On the other hand, as shown in FIG. 18, the resolution of attenuation G is in a range of 0.2-0.4 dB, which is almost the ideal characteristic because the ideal characteristic is fixed to 0.235 dB (= 60 dB/255) (ideal value).

The resistance Rs of the PIN diode when the forward current is passed through the PIN diode is represented by the following formulas (1) and (2). ${R}_{S} = \frac{{W}^{2}}{\left({μ}_{n}+{μ}_{p}\right) ⁢ {I}_{f} ⁢ τ}$ ${log}_{10} \left({R}_{S}\right) = - {log}_{10} \left({I}_{f}\right) + {log}_{10} ⁢ \left(\frac{{W}^{2}}{\left({μ}_{n}+{μ}_{p}\right) ⁢ τ}\right)$
where W denotes a thickness of the layer I, If denotes the forward current, τ denotes the life time of minor carriers, µₙ denotes the mobility of electrons, and µₚ denotes the mobility of holes.

As is clear from the above formula (2), the relationship between the logarithm of resistance Rs and the logarithm of current If is represented by a straight line with the slope of "-1", regardless of other parameters. Because the DA converter of the present disclosure is designed so that the current output may change in a logarithmic manner and the resistance Rs may change in a logarithmic manner, the linearity of FIG. 17 does not depend on the parameters of the above-mentioned formula. Hence, the DA converter of the present disclosure is flexibly effective for a PIN diode in which the parameters of the above-mentioned formula differ.

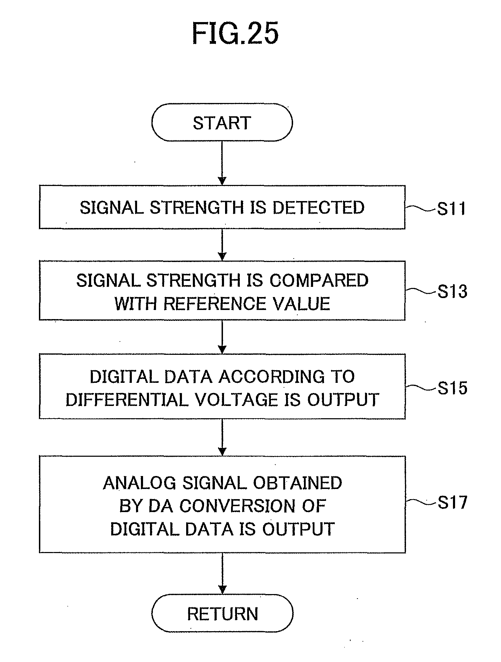

FIG. 25 is a flowchart for explaining the attenuation control method and the automatic gain control method performed by the AGC circuit 100. Next, the above-described operation of the AGC circuit 100 will be described with reference to FIG. 25.

At step 11, the sample/hold circuit 8 detects the strength of the amplified signal obtained when the high frequency signal attenuated by the PIN diode in the attenuation circuit 7 is amplified by the LNA 2. At step 13, the comparator 9 compares the detected strength with a predetermined reference value.

At step 15, the computing unit 10 outputs the digital data for controlling the amount of amplification of the high frequency signal by the PIN diode in accordance with the difference obtained by the comparison.

At step 17, the DA converter 11 performs DA conversion of the digital data output from the computing unit 10 into a control current for controlling the current which is passed through the PIN diode. The DA converter 11 outputs a corrected analog current as the control current so that a logarithmic value of the amount of attenuation of the high frequency signal is allowed to change linearly to the digital data.

Therefore, according to the present disclosure, the fluctuations of the amount of attenuation of the high frequency signal by the attenuation circuit can be minimized and the device miniaturization can be attained. For example, a radio receiver which is mounted in an automotive vehicle fundamentally requires the automatic gain control which allows the signal attenuation to change linearly.

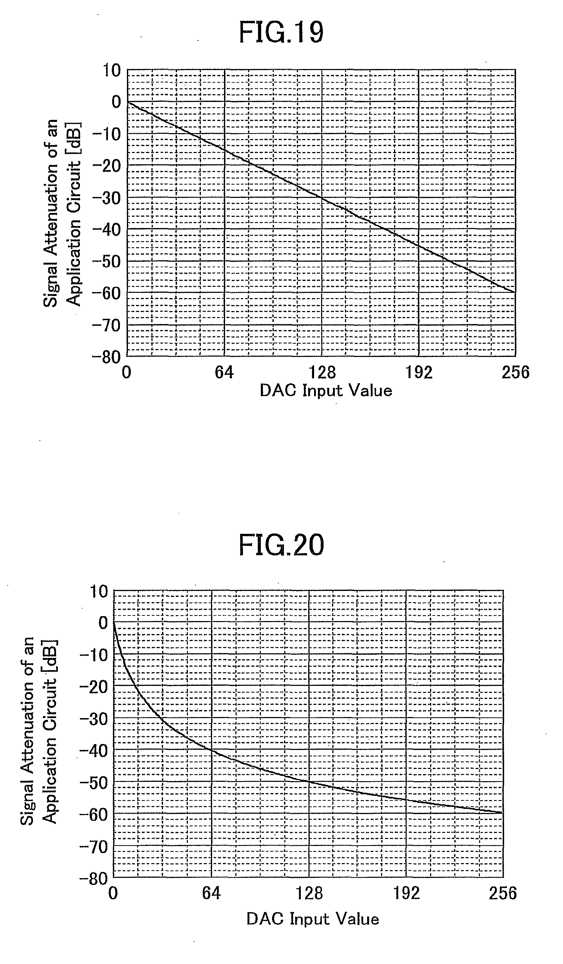

FIG. 19 shows a linear attenuation characteristic (ideal curve) in which the logarithmic value of the digital data input to the DA converter and the logarithmic value of signal attenuation are linear.

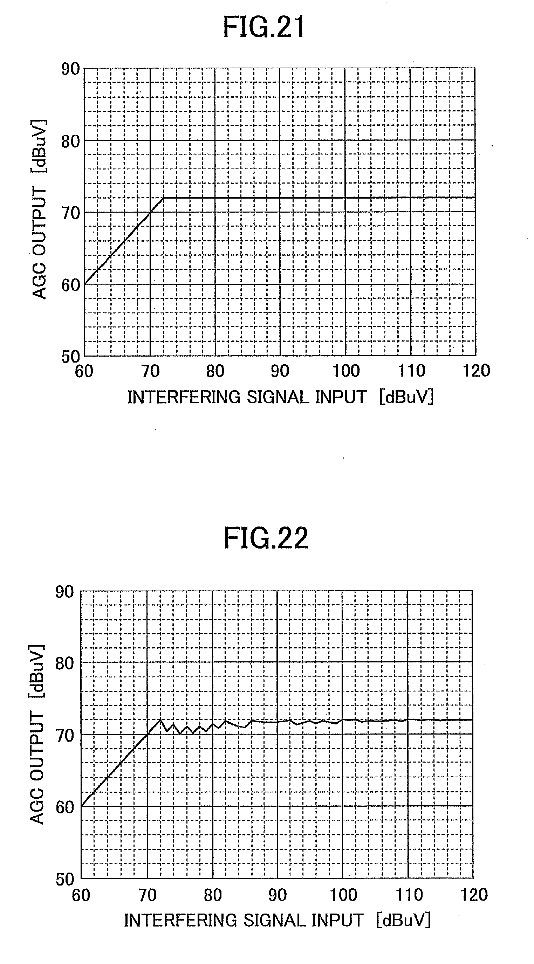

If the logarithmic value of the digital data input to the DA converter and the logarithmic value of signal attenuation are linear, the signal can be attenuated by the amount corresponding to the portion of the signal input level exceeding the reference value. Therefore, as shown in FIG. 21, even if the interfering signal input level increases, the output level of the LNA 2 after the automatic gain control is done is fixed to the reference value.

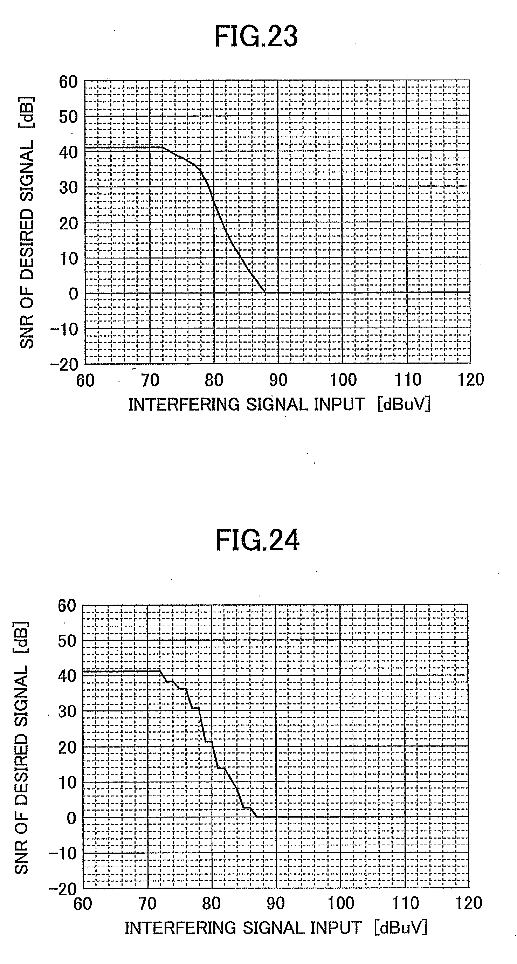

Although the demodulation SNR (audio SNR) of the desired signal decreases as the interfering signal input increases, when the logarithmic value of the digital data input to the DA converter and the logarithmic value of signal attenuation are linear, the change of SNR is continuous as shown in FIG. 23.

On the other hand, FIG. 20 shows the attenuation characteristic when the logarithmic value of the digital data input to the DA converter and the logarithmic value of signal attenuation are not linear.

In this case, as shown in FIG. 22, the output level of the LNA 2 after the automatic gain control is done is fluctuated by a slight change of the interfering signal input level. The demodulation SNR (audio SNR) of the desired signal decreases as the interfering signal input increases.

When the logarithmic value of the digital data input to the DA converter and the logarithmic value of signal attenuation are not linear, as shown in FIG. 24, the portion in which SNR does not change, and the portion in which SNR changes rapidly are present. In particular, because the fluctuations of an interfering signal are usually present, if SNR changes rapidly in such a case, the sense of incongruity on the receiver would become large.

In FIGS. 23 and 24, the SNR when the interfering signal input is 80 dBuV is compared. The SNR when the logarithmic value of the digital data input to the DA converter and the logarithmic value of signal attenuation are linear is 26 dB, as shown in FIG. 23. However, the SNR when the logarithmic value of the digital data input to the DA converter and the logarithmic value of signal attenuation are not linear is 21 dB as shown in FIG. 24. This difference of 5 dB is a very large difference on the performance comparison, and there may be a case in which the user demand cannot be satisfied by this difference.

The present disclosure is not limited to the above-described embodiments, and variations and modifications may be made without departing from the scope of the present disclosure.

The present international application is based on and claims the benefit of priority of Japanese patent application No. 2009-210209, filed on September 11, 2009, the contents of which are incorporated herein by reference in their entirety.

## Claims

1. An attenuation control device which is provided in a receiver of a high frequency signal and attenuates the high frequency signal, comprising:
a data output part to output digital data for controlling an amount of attenuation of the high frequency signal; and
a DA converter to perform DA conversion of the digital data into a control current for controlling a current which is passed through a PIN diode for attenuating the high frequency signal,
wherein the DA converter is arranged to output an analog current as the control current, the analog current being corrected to allow a logarithmic value of the amount of attenuation of the high frequency signal to change linearly to the digital data.

2. The attenuation control device according to claim 1, wherein the DA converter includes a plurality of current output blocks to output current components respectively, and the control current output by the DA converter is a sum of current components respectively output from one or more current output blocks which are chosen from among the plurality of current output blocks in response to N binary digits (where N is an integer above 2) of a first order bit portion of the digital data,
each of the plurality of current output blocks including a plurality of current sources each outputting a division current component corresponding to a current component assigned to the current source, and the current component output from each of the plurality of current output blocks is a sum of division current components respectively output from one or more current sources which are chosen from among the plurality of current sources of a corresponding one of the plurality of current output blocks in response to M binary digits (where M is an integer above 2) of a second lower-order bit portion of the digital data which is the remainder of the first order bit portion.

3. The attenuation control device according to claim 2, wherein each of the current components which are respectively assigned to the plurality of current output blocks is obtained by approximating a curve representing correlation data between a logarithmic value of the current passed through the PIN diode and the logarithmic value of the amount of attenuation of the high frequency signal, where the approximating is achieved with a set of straight lines.

4. The attenuation control device according to claim 2, wherein the DA converter includes 2^{N} current output blocks which are the plurality of current output blocks.

5. A signal attenuation device comprising:
the attenuation control device according to claim 1; and
an attenuation circuit including the PIN diode.

6. An automatic gain control device comprising:
the signal attenuation device according to claim 5;
an amplifier which amplifies the high frequency signal attenuated by the attenuation circuit; and
a signal strength detection circuit which detects a strength of an output signal of the amplifier,
wherein the data output part outputs the digital data in response to a difference between the strength detected by the signal strength detection circuit and a predetermined reference value.

7. An attenuation control method which is performed by an attenuation control device provided in a receiver of a high frequency signal to attenuate the high frequency signal, comprising:
a data output step of outputting by a data output part digital data for controlling an amount of attenuation of the high frequency signal;
a DA conversion step of performing by a DA converter DA conversion of the digital data into a control current for controlling a current which is passed through a PIN diode for attenuating the high frequency signal; and
a current output step of outputting by the DA converter a corrected analog current as the control current so that a logarithmic value of the amount of attenuation of the high frequency signal is allowed to change linearly to the digital data.

8. The attenuation control method according to claim 7, wherein the DA converter includes a plurality of current output blocks to output current components respectively, and the control current output by the DA converter in the DA conversion step is a sum of current components respectively output from one or more current output blocks which are chosen from among the plurality of current output blocks in response to N binary digits (where N is an integer above 2) of a first order bit portion of the digital data,
each of the plurality of current output blocks including a plurality of current sources each outputting a division current component corresponding to a current component assigned to the current source, and
the current component output from each of the plurality of the current output blocks is a sum of division current components respectively output from one or more current sources which are chosen from among the plurality of current sources of a corresponding one of the plurality of current output blocks in response to M binary digits (where M is an integer above 2) of a second lower-order bit portion of the digital data which is the remainder of the first order bit portion.

9. The attenuation control method according to claim 8, wherein each of the current components which are respectively assigned to the plurality of current output blocks is obtained by approximating a curve representing correlation data between a logarithmic value of the current passed through the PIN diode and the logarithmic value of the amount of attenuation of the high frequency signal, with a set of straight lines.

10. The attenuation control method according to claim 8, wherein the DA converter includes 2^{N} current output blocks which are the plurality of current output blocks.

11. An automatic gain control method which is performed by an automatic gain control device provided in a receiver of a high frequency signal to control a gain of the high frequency signal, comprising:
an amplification step of amplifying, by an amplifier, the high frequency signal attenuated by a PIN diode for attenuating the high frequency signal;
a strength detection step of detecting, by a signal strength detection circuit, a strength of the high frequency signal amplified in the amplification step;
a data output step of outputting, by a data output part, digital data for controlling an amount of attenuation of the high frequency signal by the PIN diode, in response to a difference between the strength detected in the strength detection step and a predetermined reference value;
a DA conversion step of performing, by a DA converter, DA conversion of the digital data into a control current for controlling a current which is passed through the PIN diode; and
a current output step of outputting, by the DA converter, a corrected analog current as the control current so that a logarithmic value of the amount of attenuation of the high frequency signal by the PIN diode is allowed to change linearly to the digital data.
